# EUROPEAN PATENT SPECIFICATION

(11) **EP 2 180 079 B1**
(45) Date of publication and mention of the grant of the patent: **08.02.2012**
(21) Application number: 09158065.4
(22) Date of filing: 16.04.2009
(51) Int. Cl.: C23C 14/12, H01L 51/00, B41J 2/005

(54) **Organic dry jet printing head, and printing device and method using the same**
Organischer Trockenstrahldruckkopf und Druckvorrichtung und -verfahren, die diesen verwenden
Tête d'impression à jet d'encre sèche organique et dispositif d'impression et procédé l'utilisant

(30) Priority: 22.10.2008 KR 20080103751
(43) Date of publication of application: 28.04.2010
(73) Proprietor: Korea Advanced Institute of Science and Technology, Daejeon 305-701 (KR)
(72) Inventor: Yoo, Seunghyup, 305-340, DAEJEON (KR); Yun, Changhun, 305-770, DAEJEON (KR); Cho, Hyunsu, 305-701, DAEJEON (KR)
(74) Representative: Volmer, Johannes Cornelis

(56) References cited:
- WO-A-03/020999
- US-A- 4 389 973
- US-A- 5 554 220
- US-A1- 2005 087 131

## Description

### BACKGROUND OF THE INVENTION

### 1. Field of the Invention

The present invention relates to an organic dry jet printing head and a printing device and method using the same for forming an organic semiconductor thin film at the time of fabrication of organic electronic devices, such as organic light emitting displays (OLEDs), organic solar cells (organic photovoltaic cells (OPVs)), organic thin film transistors (OTFTs) and the like.

### 2. Description of the Related Art

Organic electronic devices are being greatly spotlighted in the next-generation electronics industries. Among them, OLEDs are believed to be core parts of next-generation flat panel displays and flexible displays, OPVs have lately been researched actively according to the importance of the energy industry, and OTFTs are also being spotlighted as drive elements of organic electronic devices.

The most important part of such organic electronic devices is an organic semiconductor thin film, and the organic semiconductor thin film is generally formed through a vacuum deposition process or a solution process.

Currently, as the most commonly-used technology of fabricating an organic electronic device, a thermal evaporation-vacuum sublimation process using an ultra-high vacuum chamber is used. Although such an ultra-high vacuum deposition process has been practically used as part of a method of fabricating an excellent organic electronic device, it has the following disadvantages.

First, since high vacuum is required, equipment costs are increased and maintenance becomes difficult.

Second, since a large part of expensive semiconductor materials which are sublimed into gas is adhered to the inner wall of the vacuum chamber, it is discarded without being used to fabricate an organic electronic device, so that the loss of the expensive semiconductor materials is increased.

Third, there is a restriction in fabrication of large-area organic electronic devices due to limitation in the size of the vacuum chamber and drooping of a shadow mask, and it is difficult to realize high-resolution patterns.

For these reasons, the thermal evaporation-vacuum sublimation process using the ultra-high vacuum chamber is problematic in that it is difficult to realize high-resolution patterns required to design an organic electronic device, and it is difficult to fabricate a large-area organic electronic device, so that the production of the organic electronic device per hour is remarkably decreased, with the result that the production time of the organic electronic device is increased and the price thereof also is inevitably increased.

Therefore, in the thermal evaporation-vacuum sublimation process using the ultra-high vacuum chamber, in order to decrease the loss of the organic semiconductor material and to fabricate a large-area organic electronic device, an organic vapor phase deposition (OVPD) process, which is a top-down deposition process, has been developed. However, this OVPD is also problematic in that it cannot overcome the above problems because it is not a printing type deposition process and thus needs a shadow mask.

As an alternative of the thermal evaporation-vacuum sublimation process using the ultra-high vacuum chamber, there is a solution process using an ink jet printing process or a stamping process. In the solution process, a polymeric organic semiconductor which is relatively soluble in an organic solvent is used. Such an ink jet printing process or stamping process can be performed at atmospheric pressure, and, particularly, the ink jet printing process is used to manufacture color filters in liquid crystal displays (LCDs). Further, in this solution process, it is possible to print high-resolution patterns and to manufacture large-size organic electronic devices, unlike in the thermal evaporation-vacuum sublimation process.

However, the solution process using an ink jet printing or stamping process is also problematic in that the organic electronic devices manufactured using this solution process have much lower efficiency and lifespan than the organic electronic devices manufactured using the thermal evaporation-sublimation process, and in that it is difficult to obtain an organic semiconductor thin film having uniform thickness due to the non-uniformity of film resulting from such as the coffee-stain effect which occurs in the solution process. Generally, an organic electronic device exhibits excellent properties when it has a multi-layer thin film structure. However, the ink jet printing process or the stamping process is problematic in that it is difficult to manufacture the organic electronic device having the multi-layer thin film structure.

Recently, an organic vapor jet printing (OVJP) process, in which an organic vapor-phase material is deposited through a nozzle by combining the above-mentioned organic vapor phase deposition (OVPD) process with the printing process, has been developed [M. Shtein et al., "Method and apparatus for depositing materials," U.S. Patent Pub. No. 2005-0087131 A1].

The organic vapor jet printing (OVJP) process, disclosed in U.S. Patent Pub. No. 2005-0087131 filed by M. Shtein, includes an organic vapor jet printing (OVJP) process in which a guard flow is used and an organic vapor jet printing (OVJP) process in which the guard flow is not used. Of these two processes, the former is problematic in that an apparatus for generating a guard flow is additionally required and a large amount of gas is consumed although it can be used at atmospheric pressure, and the latter is problematic in that high-resolution patterns can be formed only when an organic material is deposited on a substrate in a vacuum of about 10 Torr or less, which is lower than an atmospheric pressure of 760 Torr. Most of all, this organic vapor jet printing (OVJP) process is problematic in that the thickness of an organic film can be non-uniform (for example, the thickness of the organic film is thicker at the corners thereof) depending on its patterns because the deposition of the organic material is conducted using a continuous gas flow, and in that it becomes sensitive to the atmospheric environment because the gas must flow at a low flow velocity in order to minutely adjust the thickness of the organic film.

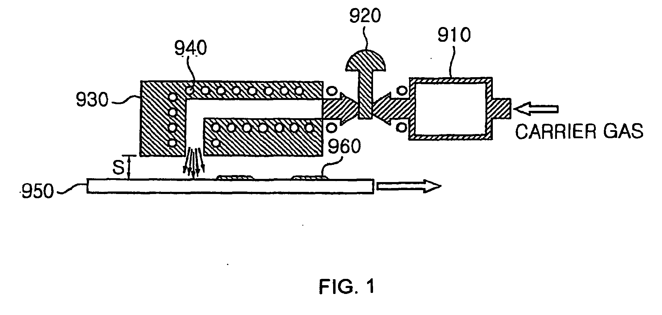

Meanwhile, FIG. 1 shows an apparatus for organic vapor jet deposition disclosed in Korean Unexamined Patent Application Publication No. 10-2004-44534. Here, the apparatus for organic vapor jet deposition is provided with a timing valve 920 between a source cell 910 and a nozzle 930. This timing valve 920 is used to form organic films 960 on a substrate 950 at regular intervals. When one continuous organic film 960 is to be formed, an organic material is continuously sprayed onto the substrate 950 in a state in which the timing valve 920 is opened, and when organic films 960 spaced apart from each other at regular intervals are to be formed, the organic material is sprayed thereonto in a state in which the timing valve 920 is closed, that is, a carrier gas is blocked.

Like the technology disclosed in U.S. Patent Pub. No. 2005-0087131 filed by M. Shtein, the technology disclosed in Korean Unexamined Patent Application Publication No. 10-2004-44534 is problematic in that it is difficult to adjust the thickness of an organic film (pattern) because the organic film (pattern) is formed by continuous gas flow, and in that the pattern circumferentially spreads at atmospheric pressure because the gas must flow at a low flow velocity in order to minutely adjust the thickness of the organic film.

A control unit is disclosed in US-A-5 554 220.

### SUMMARY OF THE INVENTION

Accordingly, the present invention has been made to solve the above-mentioned problems, and an object of the present invention is to provide an organic dry jet printing head and a printing device and method using the same, in which processes can be performed at atmospheric pressure, a large-area organic electronic device can be manufactured and high-resolution patterns can be printed, thereby improving productivity and economic efficiency.

Another object of the present invention is to provide an organic dry jet printing head and a printing device and method using the same, in which a pattern (thin film) can be formed through the repetitive injection of a high-speed jet by regularly and repeatedly opening and closing an on-off valve in a pattern (thin film) forming region using the on-off valve and a control unit, so that the spreading of the pattern is minimized even at atmospheric pressure, thereby forming a uniform and precise pattern.

In order to accomplish the above objects, an aspect of the present invention provides an organic dry jet printing head, including: a head body which stores an organic material for forming a thin film or a pattern on a substrate and which includes a nozzle for injecting the organic material onto the substrate; a carrier gas supply unit which supplies carrier gas into the head body to enable the organic material in the head body to be injected onto the substrate through the nozzle; an on-off valve which is provided between the head body and the carrier gas supply unit to control the flow of the carrier gas; and a control unit which regularly and repeatedly opens and closes the on-off valve in a thin film forming region and simultaneously controls the on-off valve such that the organic material is injected onto the substrate through the nozzle.

In the organic dry jet printing head, the head body includes a heater for heating the organic material.

The on-off valve is provided in a conduit line through which carrier gas passes and which is located between the head body and the carrier gas supply unit.

In this case, a thermal insulation system is provided in the conduit line through which the head body is connected with the carrier gas supply unit such that heat generated from the head body is not transferred to the on-off valve or the substrate. Further, a cooling system may be provided in the conduit line through which the head body is connected with the carrier gas supply unit such that heat transferred from the head body to the on-off valve or the substrate is removed.

The on-off valve is configured to be opened and closed in a carrier gas passage between an organic material storage chamber and the nozzle in the head body or toward the nozzle.

The on-off valve may be a solenoid valve operated by signals of the control unit.

Further, the on-off valve may be a microelectromechanical system (MEMS) shutter which can finely control the nozzle.

The control unit may include a pulse generator for controlling the solenoid or MEMS shutter in order to regularly and repeatedly open and close the on-off valve.

Meanwhile, the head body may include a plurality of organic material storage chambers, and the organic material storage chambers may be respectively connected with passages connected to the nozzle, and thus the organic material stored in each of the organic material storage chambers may be injected through the nozzle by the carrier gas supplied from each of the carrier gas supply units.

In this case, a mixing chamber for mixing organic materials may be provided at a location at which the passages connected with the respective organic material storage chambers join with each other, and the mixing chamber may be connected to the nozzle.

Further, the on-off valve may be provided in the passage between the organic material storage chamber and the mixing chamber or the passage between the mixing chamber and the nozzle.

Another aspect of the present invention provides a printing device using the organic dry jet printing head, including: the above-mentioned organic dry jet printing head; and a stage which faces the nozzle, which is loaded with a substrate on which a thin film is to be formed, and which is configured to change the relative position between the nozzle and the substrate by the control of the control unit.

In the printing device, the stage may be provided with a temperature controller in order to control the temperature of the substrate.

Still another aspect of the present invention provides a printing method using the organic dry jet printing head, including: heating an organic material stored in a head body to sublime the organic material; and injecting the sublimed organic material onto a substrate through a nozzle using carrier gas flow to deposit the injected organic material on the substrate, wherein, in a thin film forming region, the carrier gas flow is regularly and repeatedly blocked and unblocked, and simultaneously the organic material is deposited on the substrate to form a thin film or a pattern.

In the printing method, the carrier gas flow is blocked in a thin film non-forming region.

In the printing method, the thin film may be formed by depositing the organic material on the substrate at atmospheric pressure.

Further, when the organic material is deposited on the substrate, organic materials may be mixed with each other and then injected onto the substrate to form a thin film.

In the printing method, the carrier gas flow may be controlled using an on-off valve provided in a conduit line through which a carrier gas passes, and the thickness of the thin film formed on the substrate may be controlled by adjusting an on-off period per unit time of the on-off valve or an on:off duty ratio thereof.

### BRIEF DESCRIPTION OF THE DRAWINGS

The above and other objects, features and advantages of the present invention will be more clearly understood from the following detailed description taken in conjunction with the accompanying drawings, in which:
FIG. 1 is a sectional view showing an apparatus for organic vapor jet deposition disclosed in Korean Unexamined Patent Application Publication No. 10-2004-44534.
FIG. 2 is a sectional view showing an organic dry jet printing head according to an embodiment of the present invention;
FIG. 3 is a view showing an example of control signal settings in an organic dry jet printing head according to an embodiment of the present invention;
FIG. 4 is a sectional view showing an organic dry jet printing head according to another embodiment of the present invention;
FIG. 5 is a sectional view showing an organic dry jet printing head according to another embodiment of the present invention;
FIG. 6 is a sectional view showing an organic dry jet printing head according to another embodiment of the present invention;
FIG. 7 is a schematic view showing an on-off valve indicated by an arrow "A" in FIG. 6.
FIG. 8 is a sectional view showing a multi-type organic dry jet printing head according to an embodiment of the present invention;
FIG. 9 is a schematic view showing a printing device using the organic dry jet printing head according to an embodiment of the present invention; and
FIG. 10 is a view showing a printing method using the organic dry jet printing head according to an embodiment of the present invention.

### DESCRIPTION OF THE PREFERRED EMBODIMENTS

Hereinafter, preferred embodiments of the present invention will be described in detail with reference to the attached drawings.

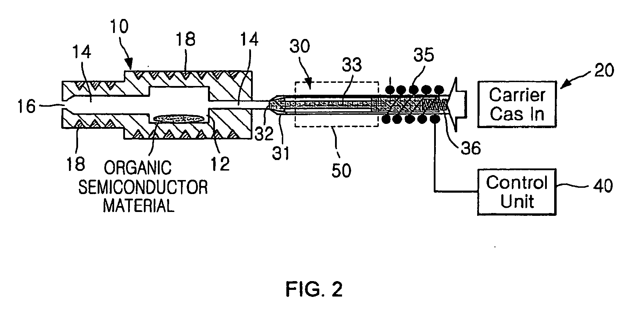

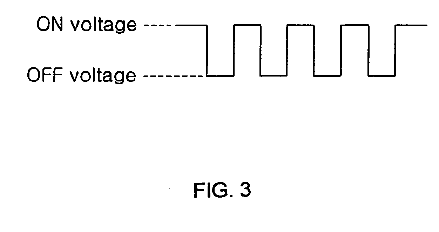

FIG. 2 is a sectional view showing an organic dry jet printing head according to an embodiment of the present invention, and FIG. 3 is a view showing an example of control signal settings in an organic dry jet printing head according to an embodiment of the present invention.

An organic dry jet printing head according to an embodiment of the present invention includes a head body 10 storing a pattern forming material such as an organic semiconductor material (hereinafter, referred to as "organic material") for forming an organic semiconductor thin film or fine pattern (hereinafter, commonly referred to as "thin film") on a substrate. The head body 10 is provided therein with an organic material storage chamber 12 for storing the organic material and a carrier gas passage 14 passing through the head body 10 via the organic material storage chamber 12.

Although the carrier gas passage 14 is illustrated in the drawing as passing through the head body 10 via the organic material storage chamber 12, the structure of the carrier gas passage 14 may be variously modified as long as carrier gas can transfer an organic material while passing through the organic material storage chamber 12.

A nozzle 16 for injecting an organic material is provided at an end of the carrier gas passage 14 of the head body 10. The nozzle 16 is configured to be integrated with the head body 10.

In the head body 10, an organic material stored in the organic material storage chamber 12 is heated to a temperature of 200 ∼ 500°C to be sublimed based on a principle similar to a thermal evaporation-sublimation method, and then the sublimed organic material is injected to the outside of the nozzle 16 using the flow of carrier gas.

Therefore, the head body 10 is provided therein with a heater 18 in order to sublime the organic material stored in the organic material storage chamber 12. The heater 18 may be an electric heater which can electrically heat the head body 10.

A carrier gas supply unit 20 is provided at the rear of the head body 10, that is, at the opposite side of the nozzle 16, such that the organic material in the head body 10 is injected onto a substrate through the nozzle 16 by supplying the carrier gas to the nozzle 16 through the carrier gas passage 14. Since the structure of a carrier gas supply unit 20 is well known in the related technical field, the detailed illustration and description thereof will be omitted.

Here, an inert gas, such as nitrogen (N₂), helium (He), argon (Ar), krypton (Kr) or the like, may be used as the carrier gas.

The injection pressure of the carrier gas may be equal to or exceed the pressure between the outside of the nozzle and the substrate. When the pressure between the outside of the nozzle and the substrate is atmospheric pressure, the injection pressure thereof may be set at 1 atm or more.

Particularly, in an embodiment of the present invention, an on-off valve 30 is provided in a conduit line which is located between the head body 10 and the carrier gas supply unit 20 and through which the carrier gas is supplied to the head body 10. The on-off valve 30 serves to control the supply of the carrier gas and to enable an organic material to be uniformly injected by the regular and repeated opening and closing of the on-off valve 30.

The on-off valve 30 may be formed of a solenoid valve in order to regularly and repeatedly open and close it. Referring to FIG. 2, the on-off valve includes a valve body 31 integrated with the conduit line or provided in the conduit line, a valve rod 33 serving to open and close a valve hole 32 (or a conduit line) while reciprocating in the valve body 31, a solenoid 35 serving to regularly reciprocate the valve rod 33, an a spring 36 serving to provide a force facing the solenoid 35. Consequently, the on-off valve 30 is configured such that the valve rod 33 is reciprocated by the magnetic force generated from the solenoid 35 and the interaction force of the spring 36, thus opening and closing the valve hole 32.

FIG. 2 shows an example of the on-off valve 30 which is collinear with the conduit line, but the present invention is not limited thereto. The on-off valve 30 may be fabricated by variously employing commonly-known solenoid valves as long as it has a structure in which the conduit line through which carrier gas passes can be regularly and repeatedly opened and closed. Meanwhile, in FIG. 2, the portion through which carrier gas passes is not provided in the rear part (around which the solenoid 35 is disposed) of the valve rod 33, but may be provided by forming a penetration channel in the rear part of the valve rod 33.

In order to regularly and repeatedly open and close the above on-off valve 30, a control unit 40 for transmitting control signals to the solenoid 35 is provided.

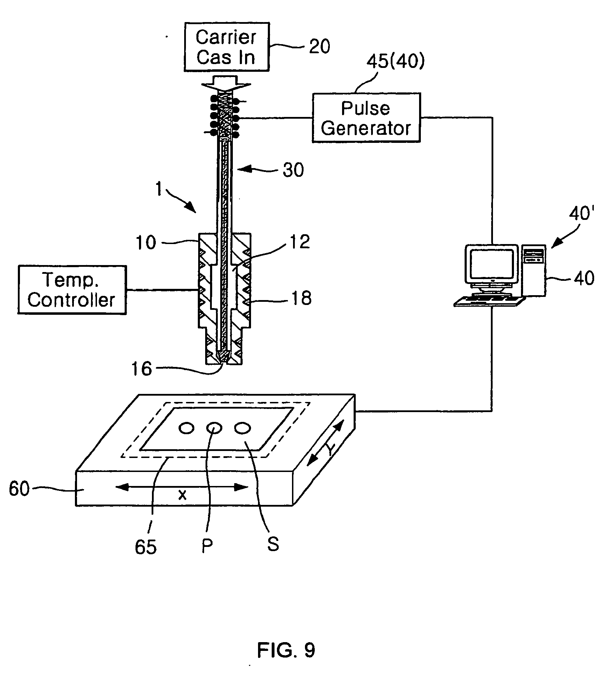

The control unit 40 may be a control computer, and may further include a pulse generator (see FIG. 9) in order to transmit regular on-off signals shown in FIG. 3 to the solenoid 35 of the on-off valve 30. This control unit 40 serves to repeatedly open and close the on-off valve by transmitting digital signals to the solenoid 35 of the on-off valve 30 through the pulse generator. In this case, a pattern is printed while controlling the on-off period or on:off duty ratio of the on-off valve 30.

Unlike a conventional valve opening and closing method in which an organic material is continuously injected in a pattern forming region and the injection of the organic material is interrupted by closing the on-off valve 30 in a pattern non-forming region, the control unit is operated such that a pattern is formed by injecting an organic material while repeatedly opening and closing the on-off valve 30 in a continuous pattern forming region.

In particular, when the thickness of a thin film formed on a substrate is finely adjusted, conventionally, the thickness thereof is adjusted by controlling the flow speed (high speed or low speed) of carrier gas, but, in the present invention, the thickness thereof is adjusted using a repetitive injection method of a high-speed jet in which the on-off period or on:off duty ratio of the on-off valve 30 is changed, thereby preventing a pattern from spreading even at atmospheric pressure. Therefore, according to the present invention, the thickness of a thin film can be finely adjusted, and thus it is possible to form a high-resolution pattern which can be realized by a commonly-known ink jet printing method.

That is, according to the present invention, since the pattern is printed using a repetitive valve opening and closing method, a thin film can be uniformly formed on a substrate, and a high-resolution pattern can be printed and a large-area organic electronic device can be manufactured as in a commonly-known ink jet printing method.

Here, the most important factor in printing a high-resolution pattern is the diameter and shape of the nozzle 16. The diameter of the nozzle 16 may be determined in proportion to the size of a pattern to be printed, and the shape of the nozzle 16 may be determined depending on the shape of a pattern of an organic electronic device to be manufactured in a state in which jet printing is not hindered.

Meanwhile, as described above, since the head body 10 is heated by the heater 18 in order to sublime an organic material, when the heat of the head body 10 is directly transferred to the on-off valve 30, the solenoid 35 may not be normally operated. Therefore, it is required that a thermal insulation system (not shown) be provided between the head body 10 and the on-off valve 30 or a cooling system 50 for cooling the on-off valve 10 be provided around the on-off valve 30.

The thermal insulation system may be installed by providing a thermal insulation material to at least one portion selected from among the head body 10 connected with the on-off valve 30, the conduit line between the head body 10 and the on-off valve 30, and the valve body 31. Since the installation structure of the thermal insulation system can be variously modified by those skilled in the art, the detailed illustration and description thereof will be omitted.

The cooling system 50 is installed to cool the on-off valve 30 by removing the heat transferred from the head body 10 to the on-off valve 30, and various types thereof, such as a coolant flow type, an air cooling type, a heat transfer type and the like, may be installed. FIG. 2 shows the position at which the cooling system 50 can be installed.

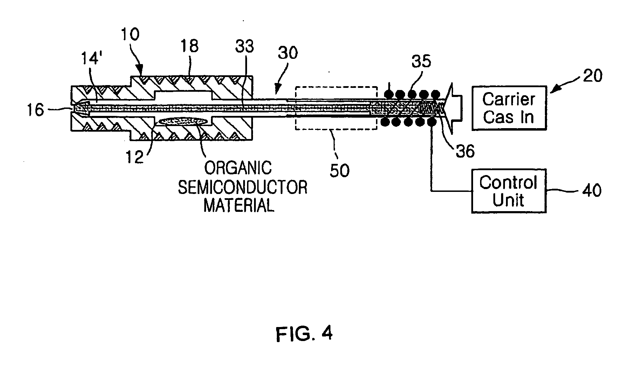

Hereinafter, various embodiments of the organic dry jet printing head according to the present invention will be described with reference to FIGS. 4 to 8. For reference, throughout the accompanying drawings, the same reference numerals are used to designate the same or similar components, and the description of the printing head described with reference to FIG. 1 is omitted.

FIG. 4 is a sectional view showing an organic dry jet printing head according to another embodiment of the present invention.

The organic dry jet printing head shown in FIG. 4 has a structure similar to that of the organic dry jet printing head described with reference to FIG. 2, except that the opening and closing portion of an on-off valve 30 is located toward a nozzle 16. Further, the opening and closing portion of the on-off valve 30 may be provided in a carrier gas passage 14' between an organic material storage chamber 12 and a nozzle 16. Further, FIG. 4 shows the organic dry jet printing head having a structure in which a valve rod 33 penetrates a head body 10, but the entire on-off valve 10 may be provided in the carrier gas passage 14' between the organic material storage chamber 12 and the nozzle 16.

Like this, when the on-off valve 30 is provided in the carrier gas passage 14' through which an organic material flows together with carrier gas, it is possible to prevent the organic material from being injected outside of the nozzle 16 or flowing out from the nozzle 16.

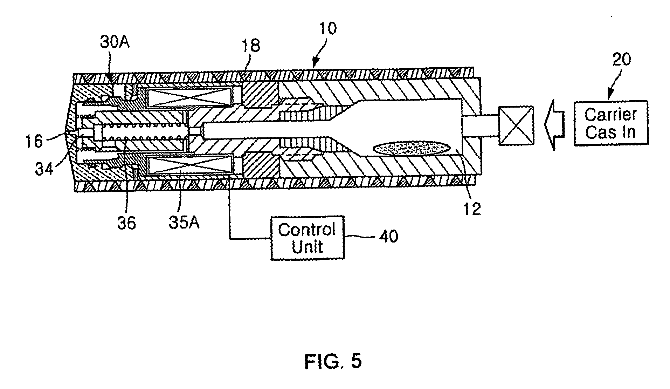

FIG. 5 is a sectional view showing an organic dry jet printing head according to another embodiment of the present invention.

Unlike the above embodiments, the organic dry jet printing head shown in FIG. 5 has a structure in which the entire on-off valve 30A including a solenoid 35A is disposed in the front portion of a head body 10 and an organic material storage chamber 12 is disposed in the rear portion of the head body 10.

In this case, since the temperature of the connection part of the on-off valve 30A and the nozzle 16 must be higher than that of the organic material storage chamber 12, the on-off valve 30A must be sufficiently resistant to high temperature. Further, in the case where a solenoid valve is used as the on-off valve 30A, a solenoid coil 35A used as an electromagnet is also resistant to high temperature. Such a heat-resistant solenoid coil 35A may be coated with magnesium oxide or laminated with glass fiber. Since this heat-resistant solenoid coil is well known in the related technical field, the detailed description thereof is omitted.

The on-off valve 30A includes a valve body 34 opening and closing a nozzle hole. In FIG. 5, since other constituents which are not described in this embodiment have identical or similar functions to those of the constituents of the above-mentioned embodiments, the description thereof is omitted.

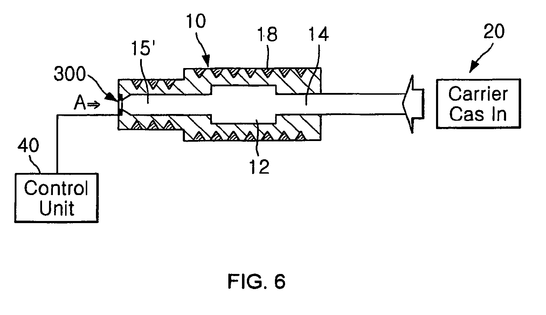

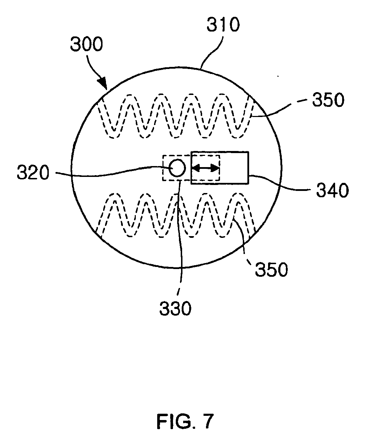

FIG. 6 is a sectional view showing an organic dry jet printing head according to another embodiment of the present invention, and FIG. 7 is a schematic view showing the on-off valve 300 indicated by an arrow "A" in FIG. 6.

In the organic dry jet printing head shown in FIGS. 6 and 7, in order to print a high-resolution pattern of several hundreds of micrometers, a microelectromechanical system (MEMS) shutter 300 is used as an on-off valve instead of a solenoid valve. Since the size of a pattern is determined by the diameter of a nozzle 16, it is preferred that the MEMS shutter 300, which can finely adjust the diameter of the nozzle 16, be used when the diameter of the nozzle 16 is small.

The MEMS shutter 300 may be provided in an end of an injection passage 15 of a head body 10, and may include a shielding plate 310 which serves to block the injection passage 15, a pinhole 320 which is formed in the center of the shielding plate 310 and serves as a nozzle, a shutter 330 which opens and closes the pinhole 320, and a microactuator 340 which moves the shutter 330.

The shielding plate 310 may be provided therein with a microheater 350 in order to heat an organic material.

Meanwhile, a commonly-known valve, which can control the opening and closing of a pinhole using a piezoelectric phenomenon, may be used instead of the MEMS shutter 300

Since other constituents, excluding the MEMS shutter 300, have identical or similar functions to those of the constituents of the above-mentioned embodiments, the description thereof is omitted.

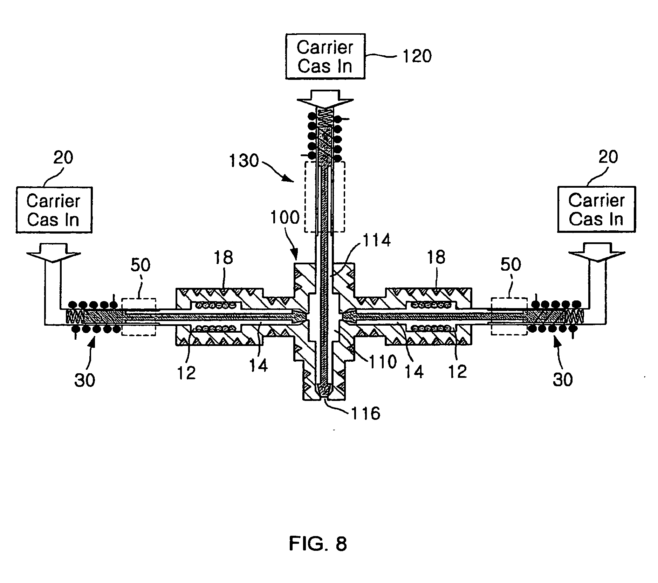

FIG. 8 is a sectional view showing a multi-type organic dry jet printing head according to an embodiment of the present invention

A multi-head is configured to deposit two or more kinds of organic materials on a substrate by simultaneously injecting them onto the substrate. Of course, a kind of organic material may be injected onto the substrate through the multi-head.

As shown in FIG. 8, the multi-head may include a mixing chamber 110 located in the center of a head body 100; and organic material storage chambers 12, carrier gas passages 14, carrier gas supply units 20, on-off valves 30, heaters 18 and cooling systems 50, which are respectively provided at both sides of the mixing chamber 110.

Here, the on-off valve shown in FIG. 4 is used for the on-off valves 30, but the on-off valve shown in FIG. 2 may also be used for the on-off valves 30.

Further, in the multi-head, a carrier gas passage 114 penetrating the mixing chamber 110 is provided in the head body 100, and a nozzle 116 is provided at an end of the carrier gas passage 114. Further, a central on-off valve 130 having a structure similar to that of the on-off valve shown in FIG. 4 is provided at the rear of the head body 100 in order to regularly and repeatedly open and close the nozzle 116, and a carrier gas supply unit 120 is located behind the central on-off valve 130.

When this multi-head is used, the central on-off valve 130 and other on-off valves 30 can be digitally opened and closed by the control unit 40, so that an organic semiconductor pattern can be easily formed at the time of fabrication of organic electronic devices, such as OLEDs, OPVs, OTFTs and the like, and the performance of the organic electronic device can be improved.

The above-mentioned organic dry jet printing heads according to the embodiments of the present invention are provided in a printing device, and are used to form a thin film (pattern) on a substrate. Hereinafter, a printing device using the organic dry jet printing head according to the present invention will be described.

FIG. 9 is a schematic view showing a printing device using the organic dry jet printing head according to an embodiment of the present invention. Here, a printing device using the organic dry jet printing head shown in FIG. 4 is described.

The printing device includes a stage 60 loaded with a substrate (S) on which a thin film (pattern) is to be formed. This stage 60 is configured to print a pattern (P) on the substrate (S) while changing the relative position between a nozzle 16 of a printing head 1 and the substrate (S) by the control unit 40.

The stage 60 may be configured such that the substrate (S) moves in the direction of the X-axis and Y-axis, and, if necessary, may also be configured such that the substrate (S) moves in the direction of the Z-axis. Besides the stage 60, the printing head 1 may be configured to move in the direction of the X-axis, the Y-axis or the Z-axis.

As such, in order to change the relative position between the nozzle 16 and the substrate (S), the position of the stage 60 or the printing head 1 is controlled. Here, since the technology of integrally controlling the position of the stage 60 or the printing head 1 using a control computer 40' is well known in the related technical field, the detailed description thereof is omitted.

However, the control computer 40' may include a control unit 40 which can regularly and repeatedly control the opening and closing of the above mentioned on-off valve 30, and this control unit 40 may be used together with a pulse generator 45.

Meanwhile, since the temperature of the organic material injected from the printing head 1 is relatively high, the stage 60 may be provided with a temperature controller 65 in order to control the temperature of the substrate (S) on which an organic semiconductor thin film is formed. In this case, it is preferred that the temperature of the substrate (S) be lower than the temperature of an organic material storage chamber 12. Generally, the temperature of the substrate (S) is in a range of 0 ∼ 30°C, but may be maintained at a temperature of more than 30°C in order to improve the crystallinity of the thin film. Further, a heat shield plate (not shown) may be provided between the nozzle 16 and the stage 60 in order to prevent the overload of the temperature controller 65 attributable to excessive heat transfer.

Hereinafter, a printing method using the organic dry jet printing head according to the present invention will be described.

Referring to FIG. 9, the stage 60 is loaded with the substrate (S) on which a pattern (P) is to be printed, and the relative position between the substrate (S) and the nozzle 16 is adjusted, thereby setting an initial pattern forming position.

Before and after the setting of the initial pattern forming position, the organic material stored in the organic material storage chamber 12 is sublimed by heating the head body 10 to a temperature of 100 ∼ 500°C using the heater 18. In this case, the temperature of all of the passages through which an organic material can pass may be maintained at a temperature equal to or higher than that of the organic material storage chamber 12, thus preventing the organic material from adhering to the passages.

Subsequently, carrier gas is introduced into the head body 10 by operating the carrier gas supply unit 20, and simultaneously the on-off valve 30 is regularly and repeatedly opened and closed by transmitting pulse output signals from the control unit 40 to the on-off valve, thereby injecting an organic material onto the substrate (S) through the nozzle 16.

In this case, the supply pressure of carrier gas may be 1 atm or more because an organic material must be injected onto the substrate (S) at atmospheric pressure.

Further, the on-off period or on:off duty ratio of the on-off valve 30 is determined by control data set in the control unit 40 in consideration of the thickness of the pattern to be formed on the substrate (S), the kind of organic material, ambient pressure and the like, and the organic material injected through the nozzle 16 is injected onto the substrate (S) through a repetitive injection method using a high-speed jet so as to form a pattern thereon.

In this way, an organic material is injected onto the substrate (S), and simultaneously a pattern is formed at a desired position of the substrate (S) while changing the relative position between the substrate (S) and the nozzle 16.

In the printing method of the present invention, a pattern is continuously formed by repeatedly opening and closing the on-off valve 30. In this case, as described above, since a pattern is formed through a repetitive injection method, it is possible to prevent the pattern from spreading, and it is possible to form a high-resolution pattern.

That is, conventionally, in order to adjust the thickness of a pattern to be formed on a substrate, an organic material is slowly injected by supplying carrier gas at low flow velocity, and simultaneously a pattern is formed. For this reason, it is not easy to adjust the thickness of the pattern, and the organic material deposited on the substrate spreads to the outside of the pattern forming region. This spreading phenomenon of the organic material becomes more serious under the condition of atmospheric pressure.

However, according to the present invention, when a pattern is formed while injecting an organic material through a repetitive injection method, a carrier gas is supplied at relatively high flow velocity, and an organic material is injected through an ON/OFF repetitive injection control method, so that it is possible to finely adjust the thickness of a pattern and form a high-resolution pattern even under the condition of atmospheric pressure.

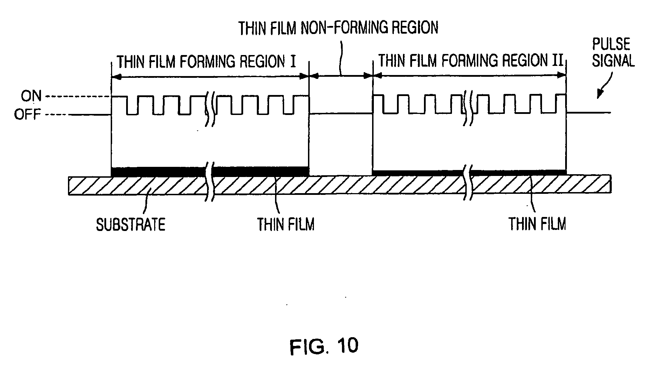

Further, the thickness of a pattern can be adjusted by suitably setting and controlling the on-off period and frequency per unit time of the on-off valve 30 or on:off duty ratio thereof. For example, under the condition that an organic material is injected at the same flow velocity, in order to increase the thickness of a pattern, as shown in 'a thin film (pattern) forming region I ' of FIG. 10, a duty ratio of ON:OFF must be adjusted in such a manner that ON is lengthened and OFF is shortened. In contrast, in order to decrease the thickness thereof, as shown in 'a thin film (pattern) forming region II ' of FIG. 10, a duty ratio of ON:OFF must be adjusted in such a manner that ON is shortened and OFF is lengthened. Further, as shown in 'a thin film (pattern) non-forming region' of FIG. 10, OFF is maintained, so that the flow of carrier gas is blocked, thereby stopping the injection of an organic material.

In conclusion, according to the present invention, since an organic material is deposited on the substrate (S) by suitably setting and controlling the on-off period, on:off duty ratio or the like of the on-off valve 30 and thus repeatedly opening and closing the on-off valve 30, it is possible to prevent a pattern from spreading even under the condition of atmospheric pressure, so that a high-resolution pattern can be formed, and the thickness of a pattern can be easily adjusted although the organic material is injected at constant flow velocity, thereby enabling the high-resolution pattern to be printed.

As described above, the organic dry jet printing head and the printing device and method using the same are advantageous in that processes can be performed at atmospheric pressure, a large-area organic electronic device can be manufactured and high-resolution patterns can be printed, thereby improving productivity and economic efficiency.

That is, according to the present invention, a pattern (thin film) can be formed through the repetitive injection of a high-speed jet by regularly and repeatedly opening and closing an on-off valve in a pattern (thin film) forming region using the on-off valve and a control unit, so that it is possible to prevent a pattern from spreading even under the condition of atmospheric pressure, with the result that a high-resolution pattern can be formed, and the thickness of a pattern can be easily adjusted by controlling the pulse width, frequency, ON/OFF ratio and the like synchronized with the opening and closing of the on-off valve although the organic material is injected at constant flow velocity.

Further, the present invention can realize both the advantages of the thermal evaporation-sublimation process using a high-vacuum chamber, mentioned in background art, by which a uniform thin film can be formed on a substrate, and the advantages of an ink jet printing process by which a high-resolution pattern can be printed and a large-area organic electronic device can be manufactured.

Accordingly, it is expected that the present invention will prove to be a great breakthrough in the mass production of organic electronic devices and will contribute greatly to the expansion of the organic electronic device market.

Organic electronic devices, such as OLEDs and the like, have the potential to constitute a large market in the future. However, currently, since it is difficult to realize high-resolution patterns and to manufacture large-area organic electronic devices, there is a problem in that their mass production is also difficult, so that their unit production cost and production time are increased. Thus, when the organic dry jet printing head and the printing device and method using the same according to the present invention are used, such a problem can be solved, so that it is expected that the present invention will contribute largely to the formation of an organic electronic device market. In particular, currently, OLEDs are applied to only small-size displays, but can be applied to even large-size displays, such as TVs, information displays and the like, in the future. Ultimately, the organic dry jet printing technology at atmospheric pressure will contribute greatly to the mass production of organic electronic devices.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. An organic dry jet printing head, comprising:
a head body (10; 100) for storing an organic material for forming a thin film or a pattern on a substrate, wherein the head body (10; 100) includes a nozzle (16; 116) for injecting the organic material onto the substrate;
a carrier gas supply unit (20) for supplying carrier gas into the head body enabling the organic material in the head body to be injected onto the substrate through the nozzle;
an on-off valve (30) which is provided in a carrier gas passage (14; 14') within the head body (10; 100) or between the head body (10; 100) and the carrier gas supply unit (20),
wherein the on-off valve (30) is configured to be opened and closed in a conduit line which is located between the head body (10; 100) and the carrier gas supply unit (20) and through which the carrier gas passes, in a carrier gas passage (14; 14') between an organic material storage chamber (12) and the nozzle (16; 116) in the head body (10; 100), or in a carrier gas passage (15) toward the nozzle (16; 116),
a heater (18) which is provided in the head body (10; 100) for heating the organic material;
**characterised by**
a control unit (40) for repeatedly opening and closing the on-off valve in a thin film forming region and simultaneously controlling the on-off valve such that the organic material is injected onto the substrate through the nozzle, and a thermal insulation system provided for the conduit line through which the head body (10; 100) is connected with the carrier gas supply unit (20) such that heat generated from the head body is not transferred to the on-off valve.

2. The organic dry jet printing head according to claim 1, wherein a cooling system (50) is provided for the conduit line through which the head body (10; 100) is connected with the carrier gas supply unit (20) such that heat transferred from the head body to the on-off valve is removed.

3. The organic dry jet printing head according to claim 1, wherein the on-off valve (30) is a solenoid valve, a microelectromechanical system (MEMS) shutter (300), a piezoelectric shutter, or a combination thereof, and is able to be operated by signals of the control unit (40).

4. The organic dry jet printing head according to claim 3, wherein the control unit (40) comprises a pulse generator (45) as a driving circuit for repeatedly opening and closing the on-off valve.

5. The organic dry jet printing head according to claim 4, wherein the pulse generator (45) is arranged for controlling a solenoid, a MEMS shutter, a piezoelectric shutter, or a combination thereof.

6. The organic dry jet printing head according to claim 1, wherein the head body (100) comprises a plurality of organic material storage chambers (12), and the organic material storage chambers (12) are respectively connected with passages (14) connected to the nozzle (116), and thus during use the organic material stored in each of the organic material storage chambers (12) is injected through the nozzle (116) by the carrier gas supplied from each carrier gas supply unit (20).

7. The organic dry jet printing head according to claim 6, wherein a mixing chamber (110) for mixing organic materials is provided at a location at which the passages (14) connected with the respective organic material storage chambers (12) join with each other, and the mixing chamber (110) is connected to the nozzle (116).

8. The organic dry jet printing head according to claim7, wherein the on-off valve (30) is provided in the passage between the organic material storage chamber (12) and the carrier gas supply unit (20), the passage (14) between the organic material storage chamber (12) and the mixing chamber (110), or the passage between the mixing chamber (110) and the nozzle (116).

9. A printing device using an organic dry jet printing head, comprising:
the organic dry jet printing head of claim 1; and
a stage (60) which faces the nozzle (16; 116), which is able to be loaded with a substrate on which a thin film is to be formed, and which is configured to change a position between the nozzle and the substrate under control of the control unit (40).

10. The printing device according to claim 9, wherein the stage (60) is provided with a temperature controller (65) for controlling a temperature of the substrate.

11. A printing method using the organic dry jet printing head according to claim 1, comprising:
heating an organic material stored in a head body (10; 100) to sublime the organic material; and
injecting the sublimed organic material onto a substrate through a nozzle (16; 116) using a carrier gas flow to deposit the injected organic material on the substrate,
wherein, in a thin film forming region, the carrier gas flow is repeatedly blocked and unblocked, and simultaneously the organic material is deposited on the substrate to form a thin film or a pattern.

12. The printing method according to claim 11, wherein the thin film is formed by depositing the organic material on the substrate at atmospheric pressure.

13. The printing method according to claim 11, wherein, when the organic material is deposited on the substrate, organic materials are mixed with each other and then injected onto the substrate to form a thin film.

14. The printing method according to claim 11, wherein the carrier gas flow is controlled using an on-off valve (30) provided in a conduit line through which the carrier gas passes, and a thickness of the thin film formed on the substrate is controlled by adjusting an on-off period or frequency per unit time of the on-off valve or an on:off duty ratio thereof.

## Patentansprüche

1. Organischer Trockenstrahldruckkopf, enthaltend:
einen Kopfkörper (10; 100) für die Aufnahme eines organischen Materials zum Ausbilden eines Dünnfilms oder eines Musters auf einem Substrat, wobei der Kopfkörper (10; 100) eine Düse (16; 116) zum Spritzen des organischen Materials auf das Substrat enthält;
eine Trägergaszuführeinheit (20) zum Zuführen von Trägergas in den Kopfkörper, wodurch das organische Material in dem Kopfkörper auf das Substrat durch die Düse gespritzt werden kann;
ein Auf-Zu-Ventil (30), das in einem Trägergasleitungsweg (14; 14') in dem Kopfkörper (10; 100) oder zwischen dem Kopfkörper (10; 100) und der Trägergaszuführeinheit (20) vorgesehen ist, wobei das Auf-Zu-Ventil (30) dazu eingerichtet ist, in einer Leitungsröhre, die sich zwischen dem Kopfkörper (10; 100) und der Trägergaszuführeinheit (20) befindet und durch die das Trägergas verläuft, in einem Trägergasleitungsweg (14; 14') zwischen einer Aufnahmekammer (12) für organisches Material und der Düse (16; 116) in dem Kopfkörper (10; 100) oder in einem Trägergasleitungsweg (15) zur Düse (16; 116) geöffnet und geschlossen zu werden; und
eine Heizeinrichtung (18), die in dem Kopfkörper (10; 100) zum Erwärmen des organischen Materials vorgesehen ist;
**gekennzeichnet durch**
eine Steuereinheit (40) zum wiederholten Öffnen und Schließen des Auf-Zu-Ventils in einem Dünnfilmausbildungsbereich und zum gleichzeitigen Steuern des Auf-Zu-Ventils derart, dass das organische Material auf das Substrat **durch** die Düse gespritzt wird, und
ein thermisches Isolationssystem, das für die Leitungsröhre vorgesehen ist, **durch** die der Kopfkörper (10; 100) mit der Trägergaszuführeinheit (20) derart verbunden ist, dass Wärme, die von dem Kopfkörper erzeugt wird, nicht auf das Auf-Zu-Ventil übertragen wird.

2. Organischer Trockenstrahldruckkopf nach Anspruch 1, bei dem ein Kühlsystem (50) für die Leitungsröhre vorgesehen ist, durch die der Kopfkörper (10; 100) mit der Trägergaszuführeinheit (20) verbunden ist, so dass Wärme, die von dem Kopfkörper auf das Auf-Zu-Ventil übertragen wird, abgebaut wird.

3. Organischer Trockenstrahldruckkopf nach Anspruch 1, bei dem das Auf-Zu-Ventil (30) ein Solenoidventil, ein Verschluss (300) eines mikroelektromechanischen Systems (MEMS), ein piezoelektrischer Verschluss oder eine Kombination daraus ist und in der Lage ist, durch Signale der Steuereinheit (40) betätigt zu werden.

4. Organischer Trockenstrahldruckkopf nach Anspruch 3, bei dem die Steuereinheit (40) einen Impulsgenerator (45) als Ansteuerkreis enthält, um das Auf-Zu-Ventil wiederholt zu öffnen und zu schließen.

5. Organischer Trockenstrahldruckkopf nach Anspruch 4, bei dem der Impulsgenerator (45) dazu eingerichtet ist, ein Solenoid, einen MEMS-Verschluss, einen piezoelektrischen Verschluss oder eine Kombination daraus zu steuern.

6. Organischer Trockenstrahldruckkopf nach Anspruch 1, bei dem der Kopfkörper (100) eine Vielzahl Aufnahmekammern (12) für organisches Material enthält und die Aufnahmekammern (12) für organisches Material jeweils mit Leitungswegen (14) verbunden sind, die mit der Düse (116) verbunden sind, und somit während der Benutzung das organische Material, das in jeder der Aufnahmekammern (12) für organisches Material aufgenommen ist, durch die Düse (116) mit Hilfe des Trägergases ausgespritzt wird, das von jeder Trägergaszuführeinheit (20) zugeführt wird.

7. Organischer Trockenstrahldruckkopf nach Anspruch 6, bei dem eine Mischkammer (110) zum Mischen organischer Materialien an einer Stelle vorgesehen ist, an der die Leitungswege (14), die mit den entsprechenden Aufnahmekammern (12) für organisches Material verbunden sind, zusammenlaufen, und die Mischkammer (110) mit der Düse (116) verbunden ist.

8. Organischer Trockenstrahldruckkopf nach Anspruch 7, bei dem das Auf-Zu-Ventil (30) in dem Leitungsweg zwischen der Aufnahmekammer (12) für organisches Material und der Trägergaszuführeinheit (20), in dem Leitungsweg (14) zwischen der Aufnahmekammer (12) für organisches Material und der Mischkammer (110) oder dem Leitungsweg zwischen der Mischkammer (110) und der Düse (116) vorgesehen ist.

9. Druckvorrichtung, in der ein organischer Trockenstrahldruckkopf Verwendung findet, enthaltend:
den organischen Trockenstrahldruckkopf nach Anspruch 1; und
eine Stufe (60), die der Düse (16; 116) zugewandt und in der Lage ist, mit einem Substrat beschickt zu werden, auf dem ein Dünnfilm auszubilden ist, und die dazu eingerichtet ist, eine Position zwischen der Düse und dem Substrat unter Steuerung der Steuereinheit (40) zu ändern.

10. Druckvorrichtung nach Anspruch 9, bei der die Stufe (60) mit einer Temperatursteuereinrichtung (65) zum Steuern einer Temperatur des Substrates versehen ist.

11. Druckverfahren unter Verwendung eines organischen Trockenstrahldruckkopfes nach Anspruch 1, umfassend:
Erwärmen eines organischen Materials, das in einem Kopfkörper (10; 100) aufgenommen ist, um das organische Material zu sublimieren; und
Spritzen des sublimierten organischen Materials auf ein Substrat durch eine Düse (16; 116) unter Verwendung eines Trägergrasstroms, um das ausgespritzte Material auf dem Substrat abzuscheiden,
wobei in einem Dünnfilmausbildungsbereich der Trägergasstrom wiederholt blockiert und freigegeben und gleichzeitig das organische Material auf dem Substrat abgeschieden wird, um einen Dünnfilm oder ein Muster auszubilden.

12. Druckverfahren nach Anspruch 11, bei dem der Dünnfilm durch Abscheiden des organischen Materials auf dem Substrat bei atmosphärischem Druck ausgebildet wird.

13. Druckverfahren nach Anspruch 11, bei dem, wenn das organische Material auf dem Substrat abgeschieden wird, organische Materialien miteinander gemischt und anschließend auf das Substrat gespritzt werden, um einen Dünnfilm zu bilden.

14. Druckverfahren nach Anspruch 11, bei dem der Trägergasstrom mit Hilfe eines Auf-Zu-Ventils (30) gesteuert wird, das in einer Leitungsröhre vorgesehen ist, durch die das Trägergas verläuft, und eine Dicke des Dünnfilms, der auf dem Substrat ausgebildet wird, durch Einstellen einer Auf-Zu-Periode oder Frequenz pro Zeiteinheit des Auf-Zu-Ventils oder relative Einschaltdauer desselben gesteuert wird.

## Revendications

1. Tête d'impression à jet d'encre sèche organique, comprenant :
un corps de tête (10 ; 100) pour stocker un matériau organique afin de former un film fin ou un modèle sur un substrat, dans laquelle le corps de tête (10 ; 100) comprend une buse (16 ; 116) pour injecter le matériau organique sur le substrat ;
une unité d'alimentation de gaz porteur (20) pour amener le gaz porteur dans le corps de tête permettant au matériau organique dans la corps de tête d'être injecté sur le substrat par le biais de la buse ;
une soupape marche - arrêt (30) qui est prévue dans un passage de gaz porteur (14 ; 14') à l'intérieur du corps de tête (10 ; 100) ou entre le corps de tête (10 ; 100) et l'unité d'alimentation de gaz porteur (20),
dans laquelle la soupape marche - arrêt (30) est configurée pour être ouverte et fermée dans une ligne de conduit qui est positionnée entre le corps de tête (10 ; 100) et l'unité d'alimentation de gaz porteur (20) et à travers laquelle le gaz porteur passe, dans un passage de gaz porteur (14 ; 14') entre une chambre de stockage de matériau organique (12) et la soupape (16 ; 116) dans le corps de tête (10 ; 100), ou dans un passage de gaz porteur (15) vers la buse (16 ; 116),
un dispositif de chauffage (18) qui est prévu dans le corps de tête (10 ; 100) pour chauffer le matériau organique ; **caractérisée par** :
une unité de commande (40) pour ouvrir et fermer de manière répétée la soupape marche - arrêt dans une région de formation de film fin et commander simultanément la soupape marche - arrêt de sorte que le matériau organique est injecté sur le substrat par le biais de la buse, et
un système d'isolation thermique prévu pour la ligne de conduit par le biais de laquelle le corps de tête (10 ; 100) est raccordé à l'unité d'alimentation de gaz porteur (20) de sorte que la chaleur générée à partir du corps de tête n'est pas transférée à la soupape marche - arrêt.

2. Tête d'impression de jet d'encre sèche organique selon la revendication 1, dans laquelle un système de refroidissement (50) est prévu pour la ligne de conduit par le biais de laquelle le corps de tête (10 ; 100) est raccordé à l'unité d'alimentation de gaz porteur (20) de sorte que la chaleur transférée du corps de tête à la soupape de marche - arrêt est retirée.

3. Tête d'impression de jet d'encre sèche organique selon la revendication 1, dans laquelle la soupape de marche - arrêt (30) est une électrovanne, un obturateur (300) de système microélectromécanique (MEMS), un obturateur piézoélectrique ou leur combinaison, et peut être actionnée par des signaux de l'unité de commande (40).

4. Tête d'impression de jet d'encre sèche organique selon la revendication 3, dans laquelle l'unité de commande (40) comprend un générateur d'impulsions (45) en tant que circuit d'entraînement pour ouvrir et fermer de manière répétée la soupape marche - arrêt.

5. Tête d'impression de jet d'encre sèche organique selon la revendication 4, dans laquelle le générateur d'impulsions (45) est agencé pour commander un solénoïde, un obturateur de MEMS, un obturateur piézoélectrique ou leur combinaison.

6. Tête d'impression de jet d'encre sèche organique selon la revendication 1, dans laquelle le corps de tête (100) comprend une pluralité de chambres de stockage de matériau organique (12) et les chambres de stockage de matériau organique (12) sont respectivement raccordées aux passages (14) raccordés à la buse (116), et ainsi pendant l'utilisateur, le matériau organique stocké dans chacune des chambres de stockage de matériau organique (12) est injecté à travers la buse (116) par le gaz porteur fourni à partir de chaque unité d'alimentation de gaz porteur (20).

7. Tête d'impression de jet d'encre sèche organique selon la revendication 6, dans laquelle une chambre de mélange (110) pour mélanger des matériaux organiques est prévue au niveau d'un emplacement auquel les passages (14) raccordés aux chambres de stockage de matériau organique (12) respectives s'assemblent entre eux et la chambre de mélange (110) est raccordée à la buse (116).

8. Tête d'impression de jet d'encre sèche organique selon la revendication 7, dans laquelle la soupape marche - arrêt (30) est prévue dans le passage entre la chambre de stockage de matériau organique (12) et l'unité d'alimentation de gaz porteur (20), le passage (14) entre la chambre de stockage de matériau organique (12) et la chambre de mélange (110), ou bien le passage entre la chambre de mélange (110) et la buse (116).

9. Dispositif d'impression utilisant une tête d'impression à jet d'encre sèche organique, comprenant :
la tête d'impression à jet d'encre sèche organique selon la revendication 1 ; et
un étage (60) qui fait face à la buse (16 ; 116) qui peut être chargé avec un substrat sur lequel un film fin doit être formé, et qui est configuré pour changer une position entre la buse et le substrat sous la commande l'unité de commande (40).

10. Dispositif d'impression selon la revendication 9, dans lequel l'étage (60) est prévu avec un contrôleur de température (65) pour contrôler une température du substrat.

11. Procédé d'impression utilisant la tête d'impression à jet d'encre sèche organique selon la revendication 1, comprenant les étapes consistant à :
chauffer un matériau organique stocké dans un corps de tête (10 ; 100) pour sublimer le matériau organique ; et
injecter le matériau organique sublimé sur un substrat par le biais d'une buse (16 ; 116) en utilisant un flux de gaz porteur pour déposer le matériau organique injecté sur le substrat,
dans lequel, dans une région de formation de film fin, le flux de gaz porteur est bloqué et débloqué de manière répétée, et simultanément le matériau organique est déposé sur le substrat pour former un film fin ou modèle.

12. Procédé d'impression selon la revendication 11, dans lequel le film fin est formé en déposant le matériau organique sur le substrat à la pression atmosphérique.

13. Procédé d'impression selon la revendication 11, dans lequel, lorsque le matériau organique est déposé sur le substrat, les matériaux organiques sont mélangés entre eux et ensuite injectés sur le substrat afin de former un film fin.

14. Procédé d'impression selon la revendication 11, dans lequel le flux de gaz porteur est contrôlé en utilisant une soupape marche - arrêt (30) prévue dans une ligne de conduit à travers laquelle le gaz porteur passe et une épaisseur du film fin formée sur le substrat est commandée en ajustant une période ou fréquence de marche - arrêt par unité de temps de la soupape marche - arrêt et son rapport de service marché arrêt.
